# FASCICULE DE BREVET EUROPEEN

(11) **EP 0 494 126 B1**
(45) Date de publication et mention de la délivrance du brevet: **07.05.1997**
(21) Numéro de dépôt: 92400012.8
(22) Date de dépôt: 03.01.1992
(51) Int. Cl.: G06K 19/077

(54) **Procédé pour la fabrication d'une carte à mémoire et carte à mémoire ainsi obtenue**
Verfahren zur Herstellung einer Speicherkarte und Speicherkarte so hergestellt
Memory card production process and memory card formed thereby

(30) Priorité: 04.01.1991 FR 9100066
(43) Date de publication de la demande: 08.07.1992
(73) Titulaire: SOLAIC (société anonyme), F-92800 Puteaux (FR)
(72) Inventeur: Audoux, Jean-Noel, F-45570 Ouzouer Sur Loire (FR); Gaumet, Michel, F-45560 Saint-Denis-en-Val (FR); Gouiller, Michel, F-45160 Olivet (FR); Thevenot, Benoît, F-45160 Olivet (FR)
(74) Mandataire: Bugnon-Hays, Claudine

(56) Documents cités:
- EP-A- 0 198 376
- FR-A- 2 588 695
- US-A- 4 216 577

## Description

La présente invention concerne un procédé pour la fabrication d'une carte à mémoire et une carte à mémoire.

On connaît des procédés de réalisation de carte à mémoire consistant à réaliser un module comportant un film support sur lequel est collée une feuille de cuivre, graver la feuille de cuivre pour délimiter des plages de contacts, fixer un circuit intégré sur le film support, établir une liaison par des fils entre les plots du circuit intégré et les plages de contact et noyer le circuit intégré et les fils de liaison dans un bloc de résine, puis fixer le module dans un corps de carte.

Selon une variante de réalisation connue la feuille de cuivre est gravée pour délimiter des languettes conductrices qui s'étendent en porte à faux d'une fenêtre réalisée dans le film support, les languettes conductrices étant ensuite soudées aux plots d'un circuit intégré inséré dans la fenêtre.

Ces procédés comportent des étapes longues et délicates à réaliser et requièrent l'usage de machines spéciales, ce qui entraîne des coûts de production élevés.

La présente invention se propose de remédier à ces inconvénients et a pour objet un procédé de fabrication d'une carte à mémoire comprenant un corps en matière isolante sur lequel est prévu un circuit intégré comportant des plots que des conducteurs relient électriquement à des contacts de lecture/écriture, caractérisé en ce qu'il comporte les étapes de : fixer le circuit intégré dans une cavité du corps de matière isolante de façon que ses plots soient tournés vers l'extérieur ; former par dépôt une première couche de vernis diélectrique sur le circuit intégré, à l'exception des plots de ce dernier et sur une partie du corps de la carte qui entoure la cavité ; former les contacts de lecture/écriture ainsi que les conducteurs reliant ces derniers aux plots respectifs du circuit intégré par dépôt d'une encre conductrice sur les plots et sur le corps de la carte ; et former par dépôt une seconde couche de vernis diélectrique sur les parties du dépôt d'encre qui ne constituent pas les contacts de lecture/écriture.

Ce procédé comporte un nombre limité d'étapes et est facile à mettre en oeuvre, ce qui permet d'abaisser de façon notable le prix de revient des cartes à mémoire.

L'invention a également pour objet une carte à mémoire comportant un corps en matière isolante et un circuit intégré fixé dans le corps de carte et ayant des plots tournés vers l'extérieur, caractérisée en ce qu'elle comporte une première couche de vernis diélectrique disposée sur le circuit intégré à l'exception des plots de ce dernier et sur une partie du corps de la carte entourant le circuit intégré, des conducteurs et des contacts de lecture/écriture en résine synthétique conductrice s'étendant sur les plots et sur une partie du corps de carte entourant le circuit intégré, et une seconde couche de vernis diélectrique s'étendant sur les conducteurs mais ne recouvrant pas les contacts de lecture/écriture.

De préférence, la cavité est réalisée avec des dimensions qui correspondent, au jeu de montage près, à celles du circuit intégré.

Les interstices existant entre les parois latérales de la cavité et celles du circuit intégré sont dans ce cas très étroits. Il suffit donc d'une petite quantité de vernis diélectrique pour les combler et dissimuler leur existence.

Selon un mode particulier de mise en oeuvre du procédé conforme à l'invention en relation avec un circuit intégré comportant un contact de masse sur la face arrière, on prévoit de réaliser dans la cavité une plage de conduction comprenant une partie interne située dans la cavité et une partie externe située hors de celle-ci et reliée à un conducteur. La cavité peut être réalisée avant la plage de conduction, par enlèvement de matière, par exemple par fraisage.

En variante, elle pourrait toutefois être réalisée après la plage de conduction, par déformation du corps de la carte, par exemple par thermoformage ou par formage par ultra-sons.

Par ailleurs, la plage de conduction peut avantageusement être réalisée par dépôt d'une encre conductrice.

En outre, la plage de conduction, les couches de vernis diélectrique et la couche d'encre conductrice peuvent être déposées par sérigraphie.

Lors de la mise en oeuvre du procédé conforme à l'invention, la première couche de vernis diélectrique peut être déposée, soit dans sa configuration définitive en une seule étape, soit de façon à ne présenter aucune discontinuité, puis percée au niveau des plots du circuit intégré et d'une partie non revêtue de vernis de la plage de conduction, son perçage pouvant par exemple être réalisé à l'aide d'un faisceau laser.

L'encre conductrice constituant les contacts de lecture/écriture et les conducteurs peut à son tour être appliquée dans sa configuration définitive en une seule étape.

Rien ne s'oppose cependant à ce qu'elle soit d'abord déposée sous la forme d'une couche ne présentant aucune discontinuité, puis enlevée sélectivement de façon à séparer les uns des autres les ensembles constitués chacun d'un conducteur et du contact de lecture/écriture associé.

On précisera encore que l'enlèvement de l'encre conductrice peut être réalisé mécaniquement, par exemple à l'aide d'un stylet gratteur ou d'un outil de coupe, thermiquement, par exemple sous l'action d'un faisceau laser, ou chimiquement.

Bien entendu, la présente invention concerne également les cartes à mémoire obtenues par la mise en oeuvre du procédé de fabrication décrit ci-dessus.

Un mode d'exécution de la présente invention sera décrit ci-après à titre d'exemple nullement limitatif en référence aux dessins annexés dans lesquels :
- la figure 1 est une vue schématique partielle de dessus d'une carte à mémoire obtenue par la mise en oeuvre du procédé conforme à l'invention ;
- la figure 2 est une vue en coupe schématique selon la ligne II-II de la figure 1 ;
- la figure 3 est une vue en coupe partielle montrant le corps de la carte après la réalisation de la cavité ;
- la figure 4 est une vue en coupe partielle montrant la corps de la carte après la réalisation de la cavité et de la plage de conduction ;
- la figure 5 est une vue partielle de dessus montrant la cavité et la plage de conduction visibles sur la figure 4 ;
- la figure 6 est une vue en coupe partielle montrant le corps de la carte après la fixation du circuit intégré dans la cavité ;
- la figure 7 est une vue partielle de dessus montrant le circuit intégré en place dans la cavité du corps de la carte ;
- la figure 8 est une vue en coupe partielle montrant le corps de la carte après le dépôt de la première couche de vernis diélectrique ;
- la figure 9 est une vue de dessus partielle montrant la première couche de vernis sur le corps de la carte ;
- la figure 10 est une vue en coupe partielle montrant le corps de la carte après le dépôt de la couche d'encre conductrice sur la couche de vernis ; et
- la figure 11 est une vue de dessus partielle montrant la couche d'encre conductrice sur la première couche de vernis.

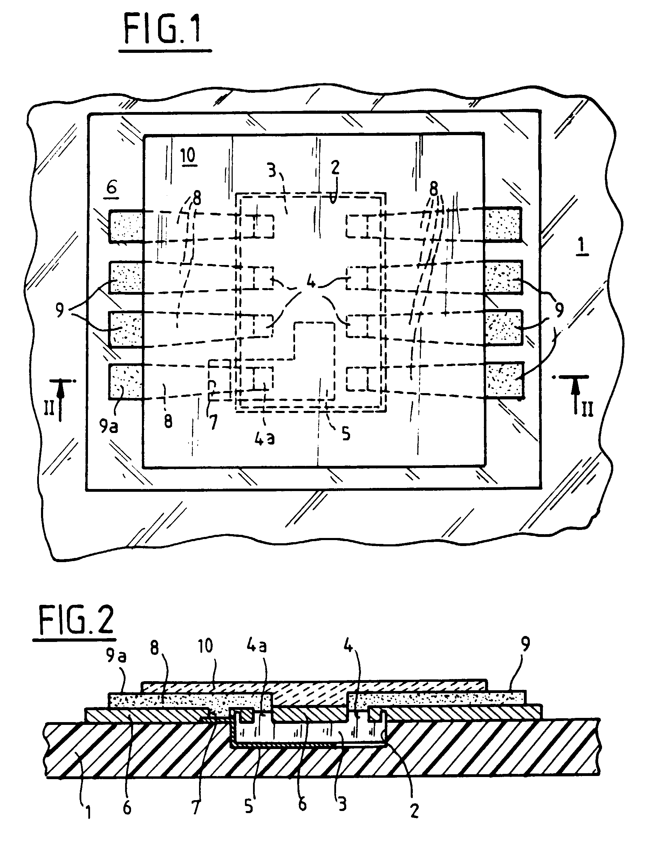

Les figures 1 et 2 sont des vues partielles respectivement de dessus et en coupe d'une carte à mémoire fabriquée par la mise en oeuvre du procédé conforme à l'invention.

Cette carte comporte tout d'abord un corps en matière isolante 1 pourvu d'une cavité 2 dans laquelle est fixé un circuit intégré 3 comportant des plots 4 dont l'un d'eux est un plot de masse 4a.

Elle comporte également une plage de conduction 5 située en partie dans la cavité 2 et en partie hors de celle-ci, et une première couche de vernis diélectrique 6 recouvrant le circuit intégré 3, à l'exception des plots 4,4a, et une partie du corps 1 qui entoure la cavité 2, à l'exception d'une zone 7 située à l'aplomb de la couche de conduction.

Elle comporte par ailleurs des conducteurs 8 situés sur la couche de vernis 6 et destinés à relier électriquement les plots 4,4a à des contacts de lecture/écriture 9 dont l'un d'eux est un contact de masse 9a, et une seconde couche de vernis diélectrique 10 recouvrant les conducteurs 8 et les parties de la première couche de vernis 6 qui surplombent le circuit intégré 3 ainsi que celles qui sont situées entre les conducteurs 8.

Dans l'exemple représenté, la cavité 2 est réalisée avec des dimensions qui correspondent, au jeu de montage près, à celles du circuit intégré 3. Elle pourrait cependant être bien plus grande que ce dernier sans que l'on sorte du cadre de la présente invention.

D'autre part, le conducteur 8 qui relie le plot de masse 4a et le contact de masse 9a est relié électriquement, au niveau de la zone 7, à la plage de conduction 5 et permet par conséquent de mettre le circuit intégré 3 à la masse lors de l'utilisation de la carte.

La plage de conduction 5 est formée par polymérisation d'une encre conductrice constituée d'une résine synthétique chargée en pigments conducteurs et apte à être déposée par sérigraphie.

Les conducteurs 8 et les contacts de lecture/écriture 9 sont également constitués d'une encre conductrice déposée par sérigraphie, la résine synthétique constituant cette encre présentant une faible résistance de ligne après polymérisation et pouvant être gravée mécaniquement, chimiquement ou thermiquement.

En ce qui concerne les vernis utilisés pour former les première et seconde couches 6 et 10, ils sont constitués de résines synthétiques identiques ou différentes et sont aptes à être déposés par sérigraphie, le vernis formant la première couche 6 ayant en outre la particularité d'être compatible avec les semi-conducteurs et de pouvoir être insolé avec un faisceau laser ou avec des radiations infrarouges, visibles ou ultra-violettes, et abradé par un faisceau laser.

On va maintenant décrire un mode particulier de mise en oeuvre du procédé conforme à l'invention.

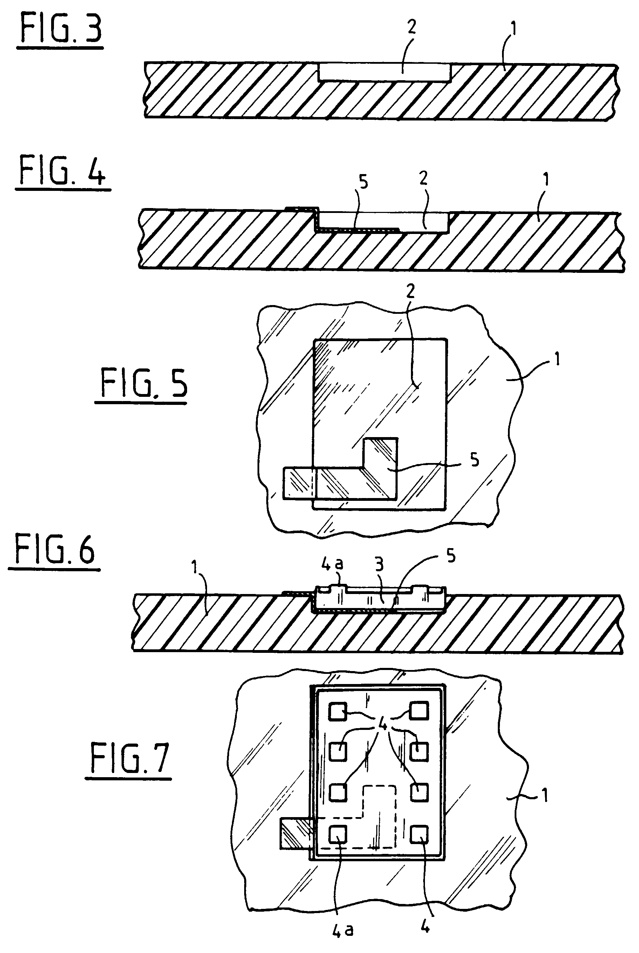

Tout d'abord, on réalise une cavité 2 dans un corps de carte 1 en matière isolante, par exemple par fraisage, après quoi l'on dépose une encre conductrice en partie dans la cavité 2 et en partie hors de celle-ci, afin de former une couche de conduction 5 (voir les figures 3 à 5).

En variante, on pourrait d'abord réaliser la couche de conduction 5 puis réaliser la cavité 2 par déformation du corps 1, par exemple par thermoformage ou par formage par ultra-sons.

On introduit ensuite dans la cavité 2 un circuit intégré 3, de façon à ce qu'il vienne en contact avec la plage de conduction 5 et à ce que ses plots 4,4a soient tournés vers l'extérieur (voir les figures 6 et 7).

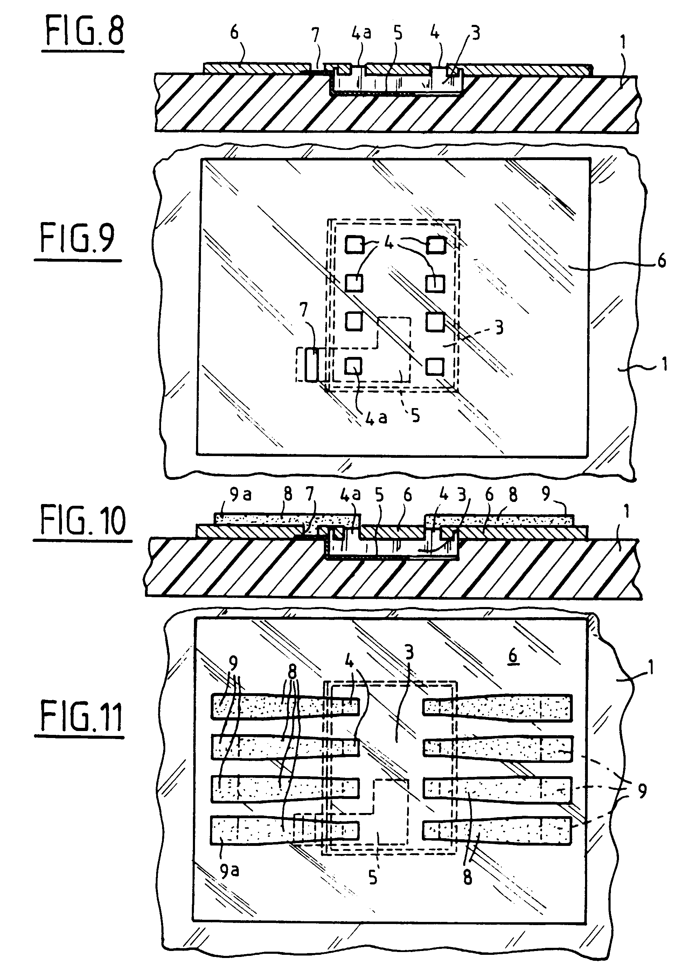

Lorsque le circuit intégré 3 est en place dans la cavité 2, on dépose par sérigraphie une première couche de vernis diélectrique 6 sur sa face supérieure, à l'exception de ses plots 4,4a, et sur une partie du corps 1 qui entoure la cavité 2, à l'exception d'une zone 7 située à l'aplomb de la plage de conduction 5 (voir les figures 8 et 9).

La couche 6 est de préférence déposée dans sa configuration définitive en une seule étape. Elle pourrait cependant être déposée de façon à ne présenter aucune discontinuité, puis être percée, par exemple à l'aide d'un faisceau laser, au niveau des plots 4,4a du circuit intégré et de la zone 7 qui surplombe la partie externe de la plage de conduction 5.

Puis, après le dépôt de la première couche 6 de vernis, on forme des contacts de lecture/écriture 9,9a ainsi que des conducteurs 8 reliant ces derniers aux plots respectifs 4,4a du circuit intégré par dépôt par sérigraphie d'une encre conductrice sur lesdits plots 4,4a, sur la première couche de vernis 6, et sur la zone 7 qui surplombe la plage de conduction 5 (voir les figures 10 et 11).

L'encre conductrice constituant les contacts de lecture/écriture 9,9a et les conducteurs 8 est de préférence appliquée dans sa configuration définitive en une seule étape. Elle pourrait cependant être d'abord déposée sous la forme d'une couche ne présentant aucune discontinuité, puis enlevée sélectivement de façon à séparer les uns des autres les ensembles constitués chacun d'un conducteur et du contact de lecture/écriture associé.

On notera ici que l'enlèvement sélectif de l'encre conductrice peut être réalisé mécaniquement, par exemple à l'aide d'un stylet gratteur ou d'un outil de coupe, thermiquement, par exemple sous l'action d'un faisceau laser, ou chimiquement.

On notera également que l'encre conductrice, en venant au contact de la plage de conduction 5 au niveau de la zone 7 permet de mettre le circuit intégré 3 à la masse lorsque le contact de masse 9a est lui-même à la masse.

Enfin, lorsque les conducteurs 8 et les contacts lecture/écriture 9,9a sont réalisés, on dépose de préférence par sérigraphie, une seconde couche de vernis diélectrique 10 sur la première couche de vernis 6 et sur l'encre, en faisant en sorte que les contacts de lecture/écriture ne soient pas recouverts (voir les figures 1 et 2).

Grâce à cette seconde couche de vernis, la carte à mémoire est alors protégée contre les rayures lors de la lecture, ce qui permet de l'utiliser dans des conditions de fonctionnement optimales.

Pour être complets, on précisera que les contacts de lecture/écriture 9,9a pourraient si nécessaire être déposés sur le corps 1 de la carte. Il suffirait en effet d'augmenter la longueur des conducteurs 8 pour parvenir à ce résultat.

Dans l'exemple de réalisation qui vient d'être décrit, le circuit intégré 3 comporte huit plots. Il va de soi que l'on ne sortirait pas du cadre de la présente invention si l'on utilisait un circuit intégré comportant un nombre de plots différent de huit.

## Revendications

1. Procédé pour la fabrication d'une carte à mémoire comprenant un corps en matière isolante (1) sur lequel est prévu un circuit intégré (3) comportant des plots (4) que des conducteurs (8) relient électriquement à des contacts de lecture/écriture (9), caractérisé en ce qu'il comporte les étapes de : fixer le circuit intégré (3) dans une cavité du corps de matière isolante de façon que ses plots soient tournés vers l'extérieur ; former par dépôt une première couche de vernis diélectrique (6) sur le circuit intégré, à l'exception des plots de ce dernier et sur une partie du corps de la carte qui entoure la cavité; former les contacts de lecture/écriture (9) ainsi que les conducteurs (8) reliant ces derniers aux plots respectifs du circuit intégré par dépôt d'une encre conductrice sur les plots et sur le corps de la carte ; et former par dépôt une seconde couche de vernis diélectrique (10) sur les parties du dépôt d'encre qui ne constituent pas les contacts de lecture/écriture.

2. Procédé selon la revendication 1, caractérisé en ce que préalablement à l'étape de fixation du circuit intégré il comporte l'étape de réaliser une plage de conduction (5) comprenant une partie interne située dans la cavité et une partie externe située hors de celle-ci, et en ce que le dépôt d'encre conductrice s'étend sur la plage de conduction pour qu'elle soit reliée à l'un des conducteurs.

3. Procédé selon la revendication 2, caractérisé en ce qu'une zone (7) située à l'aplomb de la plage de conduction (5) est réservée dans la première couche de vernis diélectrique (6).

4. Procédé selon la revendication 2 ou la revendication 3, caractérisé en ce que la cavité (3) est réalisée avant la plage de conduction (5).

5. Procédé selon la revendication 2 ou la revendication 3, caractérisé en ce que la cavité (2) est réalisée après la plage de conduction (5), par déformation du corps (1) de la carte.

6. Procédé selon l'une quelconque des revendications 1 à 5, caractérisé en ce que la première couche de vernis diélectrique (6) est déposée dans sa configuration définitive en une seule étape.

7. Procédé selon l'une quelconque des revendications 1 à 5, caractérisé en ce que la première couche de vernis diélectrique (6) est d'abord déposée de façon à ne présenter aucun discontinuité, puis percée au niveau des plots (4) du circuit intégré (3) et de la partie non revêtue de vernis de la plage de conduction (5).

8. Procédé selon l'une quelconque des revendications 1 à 7, caractérisé en ce que l'encre conductrice constituant les contacts de lecture/écriture (9) et les conducteurs (8) est appliquée dans sa configuration définitive en une seule étape.

9. Procédé selon l'une quelconque des revendications 1 à 7, caractérisé en ce que l'encre conductrice constituant les contacts de lecture/écriture (9) et les conducteurs (8) est d'abord déposée sous la forme d'une couche ne présentant aucune discontinuité, puis enlevée sélectivement de façon à séparer les uns des autres les ensembles constitués chacun d'un conducteur et du contact de lecture/écriture associé.

10. Carte à mémoire comportant un corps en matière isolante (1) et un circuit intégré (3) fixé dans le corps de carte (1) et ayant des plots (4) tournés vers l'extérieur, caractérisée en ce qu'elle comporte une première couche de vernis diélectrique (6) disposée sur le circuit intégré à l'exception des plots de ce dernier et sur une partie du corps de la carte entourant le circuit intégré, des conducteurs (8) et des contacts de lecture/écriture (9) en résine synthétique conductrice s'étendant sur les plots (4) et sur une partie du corps de carte entourant le circuit intégré, et une seconde couche de vernis diélectrique (10) s'étendant sur les conducteurs (8) mais ne recouvrant pas les contacts de lecture/écriture.

11. Carte à mémoire selon la revendication 10, caractérisée en ce qu'elle comporte en outre une plage de conduction (5) s'étendant sur le corps de carte et comprenant une partie interne en contact avec le circuit intégré (3) et une partie externe reliée à l'un des conducteurs (8).

12. Carte à mémoire selon la revendication 1, caractérisée en ce que la plage de conduction (5) est en résine synthétique conductrice.

## Patentansprüche

1. Verfahren zum Herstellen einer Speicherkarte mit einem Grundkörper (1) aus isolierendem Material, auf dem eine integrierte Schaltung (3) mit Anschlüssen (4) vorgesehen ist, die durch Leitungen (8) elektrisch mit Lese/Schreibkontakten (9) verbunden sind, dadurch **gekennzeichnet**, daß das Verfahren die folgenden Schritte umfaßt: Fixieren der integrierten Schaltung (3) in einer Vertiefung des Grundkörpers aus isolierendem Material derart, daß ihre Anschlüsse nach außen weisen, Aufbringen einer ersten Schicht (6) aus nichtleitendem Lack auf die integrierte Schaltung, wobei deren Anschlüsse ausgespart bleiben, sowie auf einen die Vertiefung umgebenden Teil des Grundkörpers der Karte, Bilden der Lese/Schreibkontakte (9) sowie der Leitungen (8), die diese Kontakte mit den jeweiligen Anschlüssen der integrierten Schaltung verbinden, durch Aufbringen einer leitenden Tinte auf die Anschlüsse und den Grundkörper der Karte, sowie Aufbringen einer zweiten Schicht (10) aus nichtleitendem Lack auf diejenigen Bereiche der Tintenschicht, die nicht die Lese-/Schreibkontakte bilden.

2. Verfahren nach Anspruch 1, dadurch **gekennzeichnet**, daß dem Schritt des Fixierens der integrierten Schaltung ein Schritt zur Bildung eines Leitungsbereiches (5) vorausgeht, der einen in der Vertiefung liegenden inneren Teil und einen außerhalb derselben liegenden äußeren Teil hat, und daß die Schicht aus leitender Tinte sich über dem Leitungsbereich erstreckt, damit dieser mit einer der Leitungen verbunden ist.

3. Verfahren nach Anspruch 2, dadurch **gekennzeichnet**, daß in der ersten Schicht (6) aus nichtleitendem Lack eine über dem Leitungsbereich (5) liegende Zone (7) ausgespart wird.

4. Verfahren nach Anspruch 2 oder Anspruch 3, dadurch **gekennzeichnet**, daß die Vertiefung (2) vor dem Leitungsbereich (5) gebildet wird.

5. Verfahren nach Anspruch 2 oder Anspruch 3, dadurch **gekennzeichnet**, daß die Vertiefung (2) nach dem Leitungsbereich (5) durch Verformen des Grundkörpers (1) der Karte gebildet wird.

6. Verfahren nach einem der Ansprüche 1 bis 5, dadurch **gekennzeichnet**, daß die erste Schicht (6) aus nichtleitendem Lack in einem einzigen Schritt in ihrer endgültigen Form aufgebracht wird.

7. Verfahren nach einem der Ansprüche 1 bis 5, dadurch **gekennzeichnet**, daß die erste Schicht (6) aus nichtleitendem Lack zunächst so aufgebracht wird, daß sie keinerlei Unterbrechungen aufweist, und dann an den Anschlüssen (4) der integrierten Schaltung (3) und an dem nicht mit Lack bedeckten Teil des Leitungsbereiches (5) entfernt wird.

8. Verfahren nach einem der Ansprüche 1 bis 7, dadurch **gekennzeichnet**, daß die leitende Tinte, die die Lese/Schreibkontakte (9) und die Leitungen (8) bildet, in einem einzigen Schritt in ihrer endgültigen Form aufgebracht wird.

9. Verfahren nach einem der Ansprüche 1 bis 7, dadurch **gekennzeichnet**, daß die leitende Tinte, die die Lese/Schreibkontakte (9) und die Leitungen (8) bildet, zunächst als eine Schicht aufgebracht wird, die keinerlei Unterbrechungen aufweist, und dann selektiv entfernt wird, um die jeweils durch eine Leitung und den dazugehörigen Lese-/Schreibkontakt gebildeten Einheiten voneinander zu trennen.

10. Speicherkarte mit einem Grundkörper (1) aus isolierendem Material und einer integrierten Schaltung (3), die im Grundkörper (1) der Karte fixiert ist und nach außen weisende Anschlüsse (4) hat, dadurch **gekennzeichnet**, daß sie umfaßt: eine erste Schicht (6) aus einem nichtleitenden Lack, die unter Aussparung der Anschlüsse auf die integrierte Schaltung sowie auf einen die integrierte Schaltung umgebenden Teil des Grundkörpers der Karte aufgebracht ist, Leitungen (8) und Lese-/Schreibkontakte (9) aus leitfähigem Kunstharz, die sich über den Anschlüssen (4) und über einem die integrierte Schaltung umgebenden Teil des Grundkörpers der Karte erstrecken, sowie eine zweite Schicht (10) aus einem nichtleitenden Lack, die sich über den Leitungen (8) erstreckt, jedoch nicht die Lese-/Schreibkontakte überdeckt.

11. Speicherkarte nach Anspruch 10, dadurch **gekennzeichnet**, daß sie ferner einen Leitungsbereich (5) enthält, der sich auf dem Grundkörper der Karte erstreckt und einen inneren, mit der integrierten Schaltung (3) in Kontakt stehenden Teil sowie einen äußeren Teil hat, der mit einer der Leitungen (8) verbunden ist.

12. Speicherkarte nach Anspruch 1, dadurch **gekennzeichnet**, daß der Leitungsbereich (5) aus leitfähigem Kunstharz ist.

## Claims

1. A process for the production of a memory card comprising a body (1) of insulating material on which is provided an integrated circuit (3) comprising studs (4) that conductors (8) electrically connect to reading/writing contacts (9) characterised in that it comprises the following steps: fixing the integrated circuit (3) in a cavity in the body of insulating material in such a way that its studs are directed towards the exterior; forming by deposit a first layer of dielectric lacquer (6) on the integrated circuit except for the studs thereof and on a part of the body of the card which surrounds the cavity; forming the reading/writing contacts (9) and the conductors (8) connecting the latter to the respective studs of the integrated circuit by deposit of a conducting ink on the studs and on the body of the card; and forming by deposit a second layer of dielectric lacquer (10) on the parts of the deposit of ink which do not constitute the reading/writing contacts.

2. A process according to claim 1 characterised in that prior to the step of fixing the integrated circuit it comprises the step of producing a conduction area (5) comprising an internal portion disposed in the cavity and an external portion disposed outside same, and that the deposit of conducting ink extends over the conduction area for it to be connected to one of the conductors.

3. A process according to claim 2 characterised in that a zone (7) in perpendicular relationship with the conduction area (5) is reserved in the first layer of dielectric lacquer (6).

4. A process according to claim 2 or claim 3 characterised in that the cavity (3) is produced before the conduction area (5).

5. A process according to claim 2 or claim 3 characterised in that the cavity (3) is produced after the conduction area (5) by deformation of the body (1) of the card.

6. A process according to any one of claims 1 to 5 characterised in that the first layer of dielectric lacquer (6) is deposited in its definitive configuration in a single step.

7. A process according to any one of claims 1 to 5 characterised in that the first layer of dielectric lacquer (6) is firstly deposited in such a way as to have no discontinuity, then it is pierced at the location of the studs (4) of the integrated circuit (3) and the part which is not covered with lacquer of the conduction area (5).

8. A process according to any one of claims 1 to 7 characterised in that the conducting ink constituting the reading/writing contacts (9) and the conductors (8) is applied in its definitive configuration in a single step.

9. A process according to any one of claims 1 to 7 characterised in that the conducting ink constituting the reading/writing contacts (9) and the conductors (8) is first deposited in the form of a layer having no discontinuity and then selectively removed so as to separate from each other the assemblies which are each formed by a conductor and the associated reading/writing contact.

10. A memory card comprising a body (1) of insulating material and an integrated circuit (3) fixed in the card body (1) and having studs (4) which are directed towards the exterior, characterised in that it comprises a first layer of dielectric lacquer (6) disposed on the integrated circuit except for the studs of the latter and on a part of the body of the card surrounding the integrated circuit, conductors (8) and reading/writing contacts (9) of conducting synthetic resin extending over the studs (4) and a part of the card body surrounding the integrated circuit, and a second layer of dielectric lacquer (10) extending over the conductors (8) but not covering the reading/writing contacts.

11. A memory card according to claim 10 characterised in that it also comprises a conduction area (5) extending over the card body and comprising an internal portion in contact with the integrated circuit (3) and an external portion connected to one of the conductors (8).

12. A memory card according to claim 1 characterised in that the conduction area (5) is of conducting synthetic resin.
